# FASCICULE DE BREVET EUROPEEN

(11) **EP 2 488 003 B1**
(45) Date de publication et mention de la délivrance du brevet: **13.11.2013**
(21) Numéro de dépôt: 12305142.7
(22) Date de dépôt: 09.02.2012
(51) Int. Cl.: H05K 1/02, H01R 9/24

(54) **Bloc électrique de contrôle utilisant la technologie des circuits imprimés pour le conducteur des lignes de puissance**
Elektrische Kontrolleinheit, die die Technologie von gedruckten Schaltkreisen für den Leiter von Leistungsleitungen verwendet
Electrical control unit using printed-circuit technology for the power-line conductor

(30) Priorité: 10.02.2011 FR 1151092
(43) Date de publication de la demande: 15.08.2012
(73) Titulaire: HAGER CONTROLS (Société par Actions Simplifiée), 67700 Saverne (FR)
(72) Inventeur: Paillard, Jean-Noël, 67120 Dachstein (FR)
(74) Mandataire: Nuss, Laurent

(56) Documents cités:
- EP-A1- 2 224 564
- WO-A1-2009/068867
- FR-A1- 2 873 501
- US-A- 4 944 684
- US-B1- 6 721 188
- US-B1- 6 797 889
- US-B1- 6 797 889
- US-B1- 6 981 878

## Description

Le domaine de la présente invention est celui de la domotique, et, plus particulièrement, des dispositifs de contrôle des différents types d'appareils électriques d'un bâtiment. L'invention a pour objet un bloc électrique de contrôle de lignes de puissance, piloté par des lignes électriques de très basse tension, notamment des lignes BUS.

Un tel bloc électrique a pour rôle essentiel de piloter la conductivité de portions de circuits de puissance, dans lesquels se trouvent des appareils électriques tels qu'un moteur de store ou de porte, des lampes, une machine à laver ou un lave-vaisselle. A cet effet, un tel bloc électrique comprend un ensemble de relais dont la fonction est de mettre ou non en communication électrique, pour une ligne de puissance appartenant au circuit de puissance et contrôlée par le bloc électrique, son entrée et sa sortie au niveau dudit bloc. L'entrée de la ligne de puissance au niveau du bloc électrique est généralement reliée au réseau d'alimentation électrique, tandis que la sortie est reliée à au moins un appareil électrique, ou inversement. L'ampérage circulant dans une ligne de puissance peut aller de 0 à 32 Ampères environ. Le fonctionnement de ces différents relais 21 est piloté par un circuit de très basse tension, interagissant notamment avec des lignes BUS, dont le voltage peut être d'environ 29 Volts. L'information véhiculée sur les lignes BUS est utilisée pour commuter les différents relais, ce qui a donc pour effet de mettre sous tension les appareils connectés aux différentes lignes de puissance que comporte le bloc électrique.

Un tel bloc électrique présente, par conséquent, la particularité de contenir, d'une part, un circuit électrique de puissance, dit de basse tension, dont l'intensité peut être de l'ordre de 0 à 32 Ampères par ligne, et, d'autre part, un circuit électrique de contrôle, dit de très basse tension de sécurité, notamment d'environ 29 Volts pour le standard EIB. Il se pose donc des problèmes d'isolation et de sécurité. En effet, il est important de garantir, au niveau du bloc, une isolation de bonne qualité entre chaque ligne de puissance, entre le circuit de puissance basse tension, comprenant ces lignes, et le circuit de contrôle très basse tension, ainsi qu'entre ces lignes de puissance et l'environnement extérieur du bloc électrique.

En outre, il est avantageux de disposer d'un bloc électrique où, pour chaque ligne de puissance, l'entrée et la sortie sont aménagées l'une en vis-à-vis de l'autre, sur des parois parallèles définissant, une fois le bloc électrique installé, la surface supérieure et la surface inférieure de ce bloc. Cette disposition facilite le câblage du bloc électrique, puisque, par exemple, l'entrée de la ligne de puissance est placée au niveau de la face supérieure du bloc, alors que la sortie de la même ligne de puissance est placée en vis-à-vis, au niveau de la face inférieure du bloc. Ce montage correspond, en outre, aux habitudes de montage d'autres produits électriques voisins, notamment de disjoncteurs de protection.

Ainsi, dans ce domaine, on connaît par FR 2 873 501 un bloc électrique où les bornes d'entrée pour les différentes lignes de puissance sont disposées côte à côte au niveau d'une surface formant la face supérieure du bloc installé, alors que les bornes de sortie sont disposées côte à côte, au niveau d'une surface située en vis-à-vis. Une fois le bloc électrique installé, la borne d'entrée et la borne de sortie de chaque ligne de puissance sont donc disposées selon un axe vertical. Il est prévu de réaliser la connexion entre l'entrée et la sortie de chaque ligne de puissance par un conducteur électrique au moyen d'une lame métallique de forme adaptée. L'isolation est assurée notamment par un enrobage de la lame avec une matière plastique. Dans la suite du document, on entend par la suite par ligne électrique la portion d'un circuit de puissance comprise dans le bloc. Elle présente, entre autres, deux bornes de connexion, respectivement pour la connexion à l'alimentation électrique et pour la connexion à la partie du circuit électrique de puissance avale au bloc.

La présente invention vise essentiellement à obtenir un moyen de connexion électrique entre l'entrée et la sortie d'une ligne de puissance d'un bloc électrique de contrôle piloté par un circuit de très basse tension, ce moyen de connexion présentant un encombrement, un coût et une difficulté de mise en place réduits, ainsi qu'une isolation accrue entre chaque ligne de puissance, entre l'ensemble des lignes de puissance et l'environnement, et entre le circuit de contrôle et les lignes de puissance. Elle vise en second lieu à limiter l'échauffement du bloc électrique, qui est du, pour sa plus grande proportion, à la circulation d'un courant élevé dans les lignes de puissance, tout en conservant un volume de bloc réduit.

A cet effet, l'invention a pour objet un bloc électrique domotique comprenant au moins deux lignes de puissance dont il contrôle l'état électrique, notamment la conductivité, un circuit de très basse tension pour son pilotage, ainsi que, pour chaque ligne de puissance électrique, d'une part, une première borne de connexion, disposée au niveau d'une première face du bloc électrique, les premières bornes (3) étant alignées en une rangées, ainsi qu'une deuxième borne de connexion, disposée au niveau d'une deuxième face du bloc électrique, la première borne (3) et la deuxième borne (5) étant en vis-à-vis, la première face et la deuxième face étant préférentiellement disposées en vis-à-vis l'une de l'autre, et, d'autre part, un conducteur, s'étendant sensiblement de la première borne à la deuxième borne et participant à mettre en communication électrique la première borne de connexion et la deuxième borne de connexion.

Ce bloc est **caractérisé en ce que** le conducteur d'au moins une ligne de puissance électrique, et préférentiellement le conducteur de chacune d'elles, est sous la forme d'un circuit imprimé, c'est-à-dire d'au moins une piste de matière conductrice, telle que du cuivre, et d'au moins une couche isolante sur laquelle ladite piste repose en ce que,
pour toutes les lignes de puissance du bloc, le conducteur est sous la forme d'un circuit imprimé, les conducteurs d'au moins deux lignes électriques, et préférentiellement les conducteurs de toutes les lignes électriques, faisant partie d'une même carte de circuit imprimé que comprend le bloc, et en ce que
pour au moins deux lignes de puissance électriques, le conducteur d'une ligne de puissance est superposé au conducteur d'une autre ligne de puissance, sur au moins une partie de leur longueur, la carte de circuit imprimé étant un circuit imprimé multicouche fait essentiellement d'une superposition de couches conductrices et de couches isolantes, la au moins une piste de matière conductrice du conducteur d'une ligne de puissance, d'une part, et la au moins une piste de matière conductrice du conducteur d'une autre ligne de puissance, d'autre part, étant superposées et disposées dans des couches conductrices différentes de la carte de circuit imprimé.

L'invention sera mieux comprise, grâce à la description ci-après, qui se rapporte à des modes de réalisation préférés, donnés à titre d'exemples non limitatifs, et expliqués avec référence aux dessins schématiques annexés, dans lesquels :

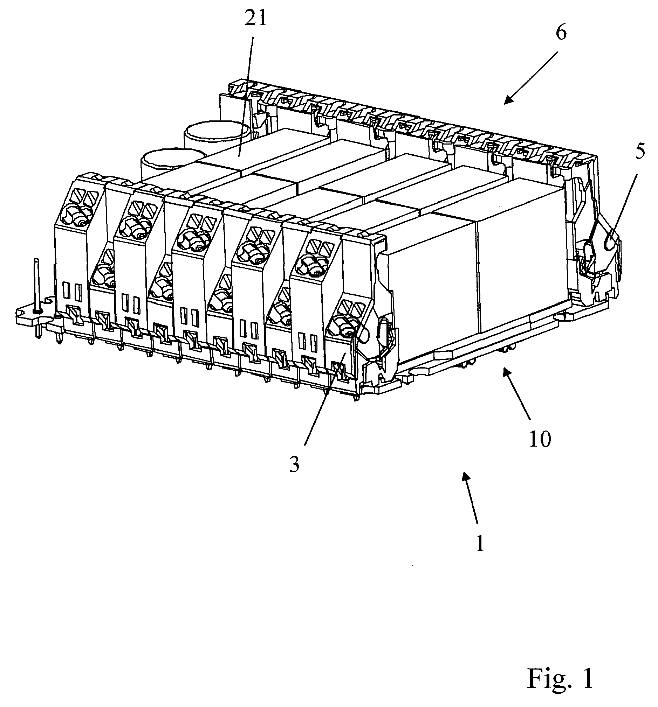

- la figure 1 montre un bloc électrique de contrôle de lignes de puissance ;
- la figure 2 schématise une carte de circuit imprimé comprenant deux conducteurs ;
- la figure 3 schématise une vue en coupe de la carte de la figure 2 selon l'axe A-A ;
- la figure 4 représente les trois pistes conductrices superposées formant trois conducteurs différents ;
- la figure 5 représente deux conducteurs stratifiés côte à côte ;
- la figure 6 représente deux conducteurs stratifiés superposés munis de vias pour la connexion ;
- la figure 7 est une vue de la face connectée d'une carte de circuit imprimée, et
- la figure 8 montre une couche conductrice de la carte de circuit imprimé de la figure 7.

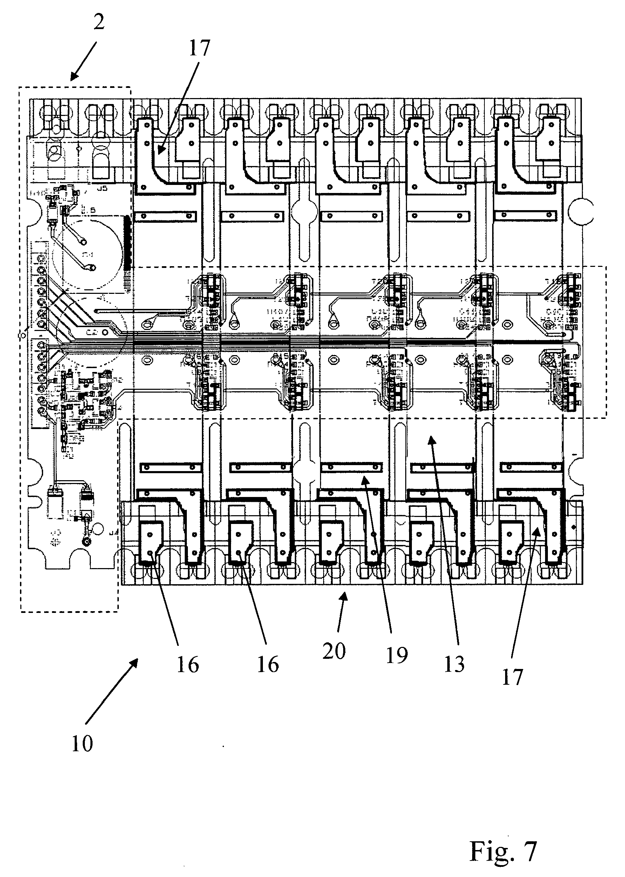

L'invention a pour objet un bloc 1 électrique comprenant au moins deux lignes de puissance dont il contrôle l'état électrique, notamment la conductivité, un circuit de très basse tension 2 pour son pilotage, ainsi que, pour chaque ligne de puissance électrique, d'une part, une première borne 3 de connexion, disposée au niveau d'une première face 4 du bloc 1 électrique, ainsi qu'une deuxième borne 5 de connexion, disposée au niveau d'une deuxième face 6 du bloc 1 électrique, la première face 4 et la deuxième face 6 étant préférentiellement disposées en vis-à-vis l'une de l'autre, et, d'autre part, un conducteur 7, s'étendant sensiblement de la première borne 3 à la deuxième borne 5 et participant à mettre en communication électrique la première borne 3 de connexion et la deuxième borne 5 de connexion. Le conducteur 7 se décompose en au moins deux parties, séparées par un relais 21 permettant de les séparer ou de les relier électriquement, ce relais 21 étant piloté par le circuit de très basse tension 2. La localisation du circuit de très basse tension 2 est représentée à la figure 7 par les traits discontinus.

Une ligne de puissance est une portion, située au sein du bloc 1, d'un circuit électrique de puissance dans lequel circule une intensité allant par exemple de 1 à au moins 32 Ampères environ et dans lequel se trouve au moins un consommateur de puissance, du type lampe électrique, actionneur de store ou de porte, etc. Cette ligne de puissance est rendue conductrice grâce au pilotage de relais 21 que comprend le bloc 1. Ces relais 21 sont pilotés par un circuit de très basse tension 2 que comprend le bloc 1, ce circuit consommant peu d'énergie, prenant préférentiellement la forme d'un circuit fonctionnant sur le standard EIB et utilisant ainsi une tension de 29 Volts. Le circuit de très basse tension 2 est donc assimilable à un circuit d'information plutôt qu'un circuit de puissance. Ce circuit de très basse tension 2 réceptionne des commandes de pilotage des lignes de puissance du bloc 1 émanant des lignes BUS et les interprète afin de piloter l'état des différents relais 21.

Lorsqu'une ligne de puissance est conductrice, le circuit électrique auquel elle appartient est sous tension, et les consommateurs qui y sont branchés sont alimentés. Dans le cas inverse, les consommateurs qui y sont branchés ne sont pas alimentés en puissance électrique. Une ligne de puissance du bloc 1 présente une première borne 3 et une deuxième borne 5, ainsi qu'un conducteur 7. Ce conducteur 7 intègre des relais 21, et se compose donc de portions conductrices électriquement connectées les unes aux autres par lesdits relais 21, le cas échéant. La communication électrique entre les portions du conducteur 7 rend donc conductrice la ligne de puissance à laquelle il appartient. Les relais 21 contrôlent préférentiellement la conductivité d'au moins une ligne de puissance, ce qui signifie qu'ils peuvent être tels qu'ils conditionnent non seulement le simple passage du courant électrique dans le conducteur 7 et donc dans la ligne du bloc 1 à laquelle il appartient, mais aussi tels qu'ils conditionnent des caractéristiques définissant ce courant, par exemple, sa tension ou son intensité, comme dans le cas d'un variateur. Les premières bornes 3 sont alignées dans une direction représentant la largeur du bloc 1. Il est donc souhaité d'avoir des premières bornes 3 les plus proches l'une de l'autre, afin d'éviter d'avoir un bloc 1 trop large.

Une même première face 4, qui forme une face d'extrémité du bloc 1, porte la première borne 3 de chaque ligne. Une deuxième face 6, située en vis-à-vis de la première face 4, porte la deuxième borne 5 de chaque ligne. Le conducteur 7, qui s'étend sensiblement de la première borne 3 à la deuxième borne 5 s'étend donc sensiblement depuis la première face 4 jusqu'à la deuxième face 6. Comme la première face 4 et la deuxième face 6 forment chacune une face d'extrémité, le conducteur 7 traverse sensiblement le bloc 1 de part en part. Les extrémités du conducteur 7 sont préférentiellement directement reliées électriquement, d'une part, à une première borne 3, et, d'autre part, à la deuxième borne 5 qui est située en vis-à-vis.

Dans une installation classique, le bloc 1 est monté sur un rail d'un coffret électrique, et tant la première face 4 que la deuxième face 6 sont horizontales une fois le bloc 1 installé, et délimitent respectivement le bloc 1 par le haut et par le bas. Le montage est ainsi aisé et le câblage clair et rapide à comprendre puisque chaque ligne de puissance que comprend le bloc 1 s'étend verticalement, avec une première borne 3 située sur une face horizontale supérieure du bloc 1, et une deuxième borne 5 située sur une face horizontale inférieure de ce bloc 1.

Selon l'invention, le conducteur 7 d'au moins une ligne de puissance électrique, et préférentiellement le conducteur 7 de chacune d'elles, est sous la forme d'un circuit imprimé, c'est-à-dire d'au moins une piste 8 de matière conductrice, telle que du cuivre, et d'au moins une couche isolante 9 sur laquelle ladite piste 8 repose. La matière isolante utilisée pour réaliser la au moins une couche isolante 9 du circuit imprimé formant le conducteur 7 ainsi que la qualité des interfaces entre la matière conductrice et la matière isolante garantissent une bonne isolation électrique, d'une part, entre les différents conducteurs 7, et, d'autre part, entre chaque conducteur 7 et l'extérieur. La technologie des circuits imprimés est donc utilisée pour la réalisation du conducteur 7 d'au moins une ligne de puissance du bloc 1. Cette technologie consiste à réaliser une fine piste 8 de matière conductrice sur un support isolant, préférentiellement une couche isolante 9. La piste 8 de matière conductrice crée donc une couche conductrice 11 et peut ensuite être à nouveau recouverte d'une couche isolante 9, si nécessaire. Un circuit imprimé peut aussi consister en un circuit imprimé multicouche, fait d'une superposition, en alternance, de couches conductrices 11 portant des pistes 8 et de couches isolantes 9.

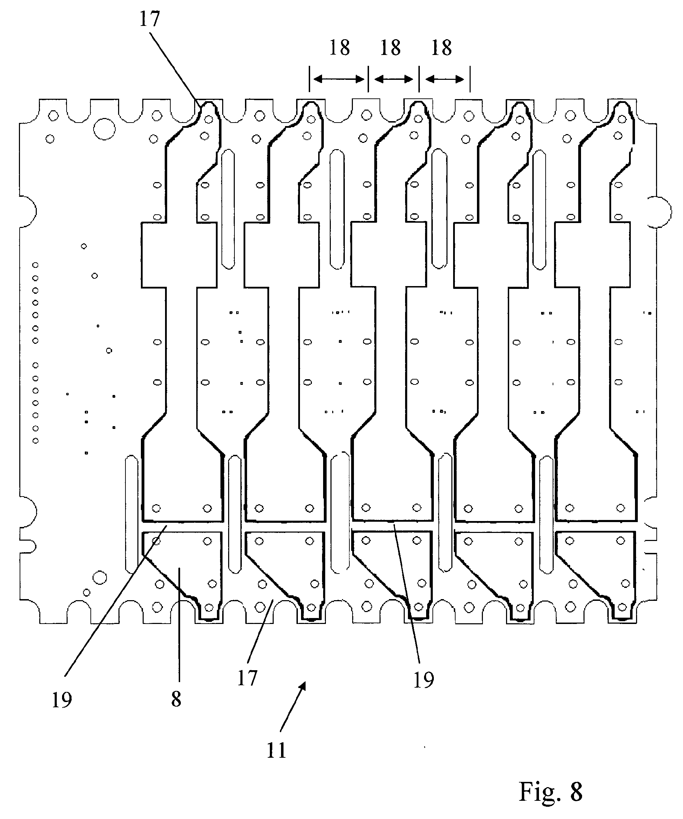

Selon une caractéristique supplémentairepropre à l'invention, illustrée aux figures 7 et 8 et permettant notamment de réduire le nombre de pièces du bloc 1, pour toutes les lignes de puissance du bloc 1, le conducteur 7 est sous la forme d'un circuit imprimé, les conducteurs 7 d'au moins deux lignes électriques, et préférentiellement les conducteurs 7 de toutes les lignes électriques, faisant partie d'une même carte de circuit imprimé 10 que comprend de bloc 1. Ainsi, une seule carte de circuit imprimé 10 porte l'ensemble des conducteurs 7 des différentes lignes de puissance du bloc 1.

Selon une caractéristique supplémentaire possible, illustrée en particulier à la figure 7, réduisant encore le nombre de pièces, et simplifiant donc le montage et réduisant le coût du bloc 1, la carte de circuit imprimé 10 comprend, en outre, des portions conductrices appartenant au circuit de très basse tension 2 et en accueille au moins une partie des composants. Il est donc possible de n'utiliser qu'une seule carte de circuit imprimé 10 tant pour le circuit de très basse tension 2 que pour le circuit de puissance interne au bloc 1 et auquel appartient l'ensemble des lignes de puissance. L'isolation électrique entre le circuit de très basse tension 2 et les lignes de puissance est assuré, entre autres, par la très faible conductivité électrique du matériau utilisé pour réaliser la au moins une couche isolante 9 de la carte de circuit imprimé 10 ainsi que de la matière isolante, entourant la piste 8 au sein d'une couche conductrice 11.

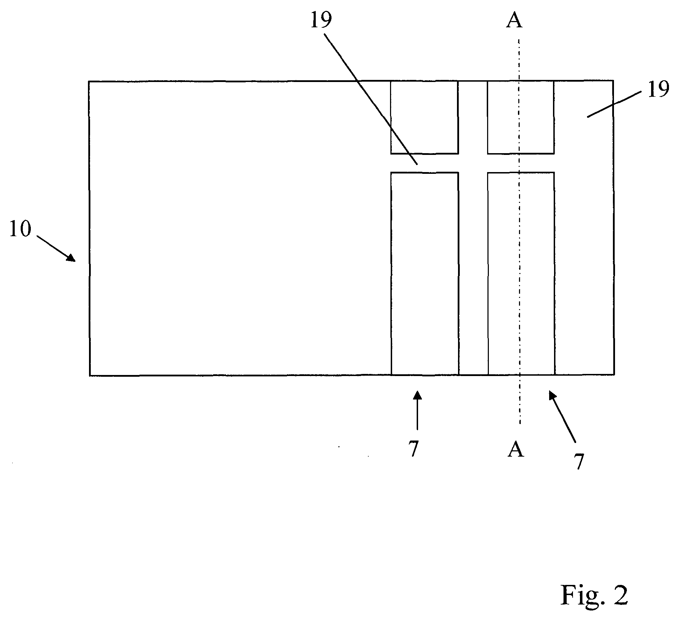

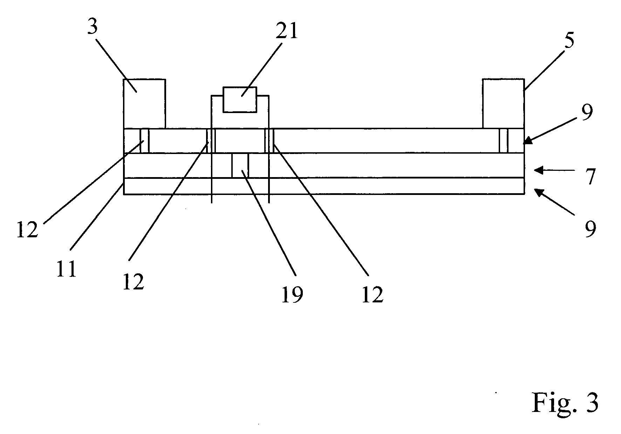

Ces caractéristiques amènent donc à un premier type de réalisations, illustré aux figures 2 et 3 sous la forme d'un bloc 1 contrôlant deux lignes de puissance dont les conducteurs 7 forment deux pistes situées côte à côte. Un tel bloc 1 comporte une carte de circuit imprimé 10, qui comprend des portions conductrices du circuit de très basse tension 2 ainsi qu'au moins une partie de ses composants électroniques. Le bloc 1 comprend et contrôle deux lignes de puissance, pilotées par le circuit de très basse tension 2. Chaque ligne de puissance intègre un conducteur 7, s'étendant sensiblement de la première borne 3 jusqu'à la deuxième borne 5 de la ligne de puissance. Chacun des conducteurs 7 comprend au moins un relais 21, dont l'état permet au conducteur 7 de mettre en communication électrique la première borne 3 et la deuxième borne 5 de façon à au moins fermer électriquement le circuit dans lequel se trouve la ligne à laquelle il appartient. Pour chacune des deux lignes de puissance du bloc 1, le conducteur 7 est réalisé sous la forme d'une seule piste 8 de matière conductrice de la carte de circuit imprimé 10, ces deux pistes 8 étant situées côte à côte dans la même couche conductrice 11 et éventuellement séparées par de la matière isolante. La piste 8 du conducteur 7 d'une ligne de puissance se trouve à côté de la piste 8 du conducteur de l'autre ligne. La carte de circuit imprimé 10 prend donc la forme d'une plaque de matière isolante, présentant une couche isolante 9, sur laquelle sont aménagées des pistes 8 pour les conducteurs 7, ainsi que des portions conductrices appartenant au circuit de très basse tension 2. Préférentiellement, les pistes 8 se trouvent, une fois le bloc 1 installé, du côté de la carte de circuit imprimé 10 opposé à la portion du bloc 1 visible par l'utilisateur.

Les pistes 8 de la carte de circuit imprimé 10 sont éventuellement recouvertes d'une couche isolante 9, ou d'un isolant tel qu'un vernis de protection ou qu'une matière plastique. De façon générale, notamment dans ce premier type de réalisations, lorsque le bloc 1 comprend plus de deux lignes de puissance, le conducteur 7 de chacune des lignes de puissance prend donc essentiellement la forme d'une seule piste 8 de matière conductrice, ces pistes 8 étant toutes aménagées dans la même couche conductrice 11 d'une même carte de circuit imprimé 10, ces pistes 8 étant disposées les unes à côté des autres, la carte de circuit imprimé 10 intégrant, en outre, des portions conductrices appartenant au circuit de très basse tension 2, contrôlant l'état de relais 21 que comprennent les différents conducteurs 7.

Afin d'augmenter l'ampérage qu'il est possible de faire transiter dans chaque conducteur 7, et donc dans la ligne de puissance à laquelle il appartient, sans toutefois dépasser un seuil de température, mais sans augmenter l'encombrement du bloc 1, et selon une caractéristique supplémentaire propre à l'invention, pour au moins deux lignes de puissance électriques, le conducteur 7 d'une ligne de puissance est superposé au conducteur 7 d'une autre ligne de puissance, sur au moins une partie de leur longueur, la carte de circuit imprimé 10 étant un circuit imprimé multicouche fait essentiellement d'une superposition de couches conductrices 11 et de couches isolantes 9, la au moins une piste 8 de matière conductrice du conducteur 7 d'une ligne de puissance, d'une part, et la au moins une piste 8 de matière conductrice du conducteur 7 d'une autre ligne de puissance, d'autre part, étant superposées et disposées dans des couches conductrices 11 différentes de la carte de circuit imprimé 10. Ainsi, il est possible d'augmenter la largeur de la piste 8 qui forme un conducteur 7, ce qui permet d'augmenter l'ampérage qui peut y circuler, sans pour autant dépasser un seuil d'échauffement de sécurité ni augmenter la largeur du bloc 1. Deux éléments sont dits superposés si leurs projections orthogonales dans le plan que forme la carte de circuit imprimé 10 sont sensiblement identiques et au moins partiellement jointes. Ainsi, la superposition représente, pour deux éléments, le fait de former des projections similaires dans le plan de la carte de circuit imprimé 10.

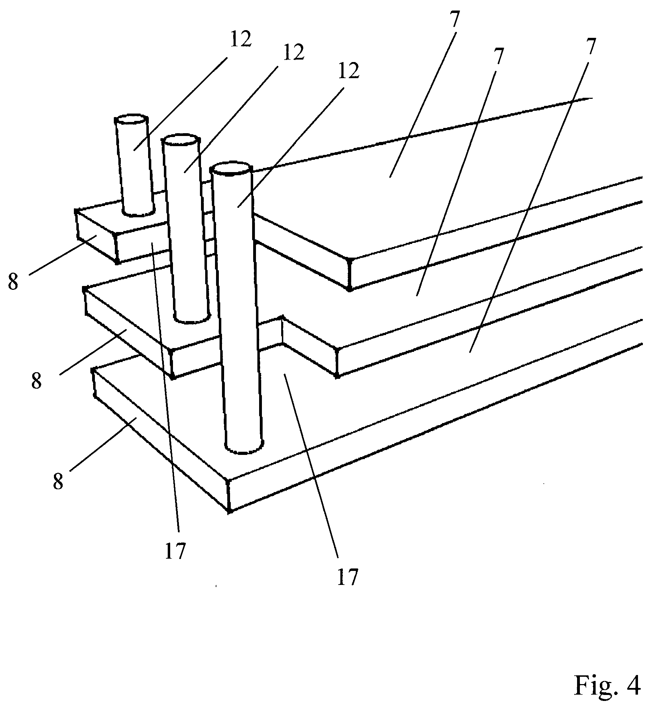

Une application de cette caractéristique amène à un deuxième type de réalisations, illustré à la figure 4 sous la forme d'un bloc 1 électrique contrôlant trois lignes de puissance, dans lequel chacun des conducteurs 7 est sous la forme d'une unique piste 8 de matière conductrice d'une carte de circuit imprimé 10, cette dernière comprenant aussi des portions du circuit de très basse tension 2, ces différentes pistes 8, au nombre de trois, étant superposées sur pratiquement toute leur longueur et disposées dans des couches conductrices 11 différentes de ladite carte de circuit imprimé 10, cette dernière étant donc un circuit imprimé multicouche.

Ainsi, la piste 8 du conducteur 7 de la première ligne de puissance est aménagée dans une première couche conductrice 11 de la carte de circuit imprimé 10, la piste 8 du conducteur 7 de la deuxième ligne de puissance étant aménagée dans une seconde couche conductrice 11 de ladite carte, et la piste 8 du conducteur 7 de la troisième ligne de puissance étant aménagée dans une troisième couche conductrice 11 de ladite carte. De façon générale, chaque piste 8 formant un conducteur 7 est installée dans une couche conductrice 11 différente de la carte de circuit imprimé 10. Les pistes 8 sont donc avantageusement superposées, dans une direction d'observation perpendiculaire au plan des différentes couches formant la carte de circuit imprimé 10. Les couches conductrices 11, portant les pistes 8, sont séparées par des couches isolantes 9, la carte de circuit imprimé 10 en comprenant donc au moins deux intercalée, pour l'une d'elle, entre les première et deuxième couches conductrices 11, et, pour l'autre, entre les deuxième et troisième couches conductrices 11.

Ainsi, la piste 8 qui forme le conducteur 7 d'une ligne de puissance parmi les trois peut s'étendre, non seulement dans une zone séparant la première borne 3 et la deuxième borne 5 de ladite ligne, mais aussi dans une zone séparant la première borne 3 et la deuxième borne 5 d'une autre ligne, voire aussi dans une zone séparant la première borne 3 et la deuxième borne 5 de la dernière des trois lignes de puissance. En considérant que deux premières bornes 3 adjacentes sont séparées d'une largeur valant une unité 18, seule une piste 8 d'une largeur maximale d'une unité 18 peut être utilisée pour réaliser le conducteur 7 de chaque ligne de puissance dans le cas où les conducteurs 7 ne sont pas superposés. Lorsque, pour au moins deux lignes de puissance électriques, le conducteur 7 d'une ligne de puissance est superposé au conducteur 7 d'une autre ligne de puissance, sur au moins une partie de leur longueur, il devient possible d'utiliser, pour chaque conducteur 7, une piste 8 unique d'une largeur plus élevée, à savoir, notamment, d'environ deux unités 18 si ce sont les conducteurs 7 de deux lignes de puissance qui se chevauchent, voire de trois unités 18 si ce sont les conducteurs 7 de trois lignes de puissance qui se chevauchent, comme dans la figure 4.

De façon générale, notamment dans ce deuxième type de réalisations, la au moins une piste 8 qui forme le conducteur 7 d'une ligne de puissance a une largeur maximale correspondant à autant d'unités 18 que le nombre de conducteur 7 de l'ensemble de conducteurs 7 superposés auquel il appartient. Bien entendu, la largeur de la au moins une piste 8 est adaptée pour laisser passer les pattes de composants électroniques situés sur une face de la carte de circuit imprimé 10 dite face connectée 13, et peut donc ne pas être constante sur toute la longueur du conducteur 7.

Il peut aussi être envisagé que seuls les conducteurs 7 de deux lignes de puissance parmi les trois du bloc 1 se superposent, le conducteur 7 de la troisième ligne de puissance n'étant superposé avec aucun autre.

Dans ce deuxième type de réalisations, et selon une caractéristique supplémentaire possible, le conducteur 7 d'au moins une ligne de puissance présente au moins une cheminée 12 s'étendant, en direction d'une face connectée 13 de la carte de circuit imprimé 10, depuis l'une de ses pistes 8, préférentiellement sa piste 8 la plus proche de ladite face connectée 13, en traversant éventuellement au moins une piste 8 d'un autre conducteur 7 alors ajourée de façon à ne pas être en contact avec ladite cheminée 12 notamment en présentant une poche 17. Cela permet de connecter électriquement, à partir d'une même face de la carte de circuit imprimé 10 formant une face connectée 13, une piste 8, du conducteur 7 de n'importe quelle ligne et située dans une couche de la carte de circuit imprimé 10 séparée de ladite face connectée 13 par au moins une autre couche conductrice 11 comprenant une piste 8 du conducteur 7 d'une autre ligne. Il est ainsi possible de réaliser, à partir d'un seul côté de la carte de circuit imprimé 10, c'est-à-dire à partir de la face connectée 13, une connexion électrique des différents conducteurs 7 superposés. De façon générale, une poche 17 d'un conducteur 7 forme une zone où il ne se superpose pas à au moins un autre conducteur 7.

Pour une piste 8 d'un conducteur 7, chaque autre piste 8, appartenant à un autre conducteur 7 et disposée entre elle et la face connectée 13 de la carte de circuit imprimé 10, est donc ajourée de façon adaptée, notamment en présentant une poche 17 dans laquelle peut passer la cheminée 12, de sorte à éviter un contact électrique entre la cheminée 12, reliée audit conducteur 7, et ladite autre piste 8, dudit autre conducteur 7.

Ainsi, dans le mode de réalisation particulier précédemment décrit où le bloc 1 présente trois lignes de puissance, comprenant chacune un conducteur 7 sous la forme d'une seule piste 8, chaque piste 8 est reliée à une cheminée 12, ou via, toutes les cheminées 12 s'étendant vers la même face de la carte de circuit imprimé 10, c'est-à-dire vers la face connectée 13. Ces cheminées 12 sont préférentiellement au nombre d'au moins quatre par connecteur 7 et aménagées à proximité, de la première borne 3, de la deuxième borne 5, ainsi que de part et d'autre d'une discontinuité 19 de la piste 8 au niveau de laquelle se trouve au moins un relais 21.

Dans le bloc 1, la première borne 3 de la deuxième ligne de puissance se trouve entre les premières bornes 3 de la première et la troisième ligne de puissance. La première piste 8, formant le conducteur 7 de la première ligne de puissance est la plus proche de la face connectée 13 de la carte de circuit imprimé 10 et peut éventuellement présenter une première cheminée 12 destinée à traverser une couche isolante 9 sur laquelle des composants du circuit de très basse tension 2 sont montés et portent ainsi la face connectée 13. Cette première piste 8 peut donc avoir, au moins localement, une largeur maximale de trois unités 18 et s'étend globalement entre les trois premières bornes 3 et les trois deuxièmes bornes 5 dans une première couche conductrice 11 de la carte de circuit imprimé 10. La première piste 8 présente néanmoins une largeur plus faible à proximité de la première borne 3 de la première ligne, rétrécissant donc depuis une largeur correspondant éventuellement à trois unités 18 jusqu'à une largeur correspondant au maximum à une unité 18. La première piste 8 a, dans la figure 4, une forme de rectangle muni de deux extensions sur ses plus petits côtés, et est absente de la zone en vis-à-vis des premières bornes 3 des deuxième et troisième lignes. La première borne 3 de la première ligne de puissance est reliée à la première piste 8, par la première cheminée 12, le cas échéant.

La deuxième piste 8, formant le conducteur 7 de la deuxième ligne de puissance et séparée de la première piste 8 par une couche isolante 9, peut elle aussi avoir, au moins localement, une largeur maximale de trois unités 18 et s'étend aussi globalement entre les trois premières bornes 3 et les trois deuxièmes bornes 5, mais dans une deuxième couche conductrice 11 de la carte de circuit imprimé 10, plus éloignée de la face connectée 13 que la première couche conductrice 11. La forme de la deuxième piste 8 est telle qu'elle est absente de la zone située en vis-à-vis de la première borne 3 de la troisième ligne de puissance. La deuxième piste 8 présente une deuxième cheminée 12 qui s'étend en direction de la face connectée 13 de la carte de circuit imprimée 10, à proximité de la première borne 3 de la deuxième ligne. La deuxième cheminée 12 peut donc être reliée à la première borne 3 de la deuxième ligne de puissance puis rejoindre la deuxième piste 8 en traversant la première couche conductrice 11 de la carte de circuit imprimé 10, compte tenu de la forme ajourée, notamment effilée, de la première piste 8 qui s'y trouve, et donc en traversant la première piste 8, formant le conducteur 7 de la première ligne.

Enfin, la troisième piste 8, formant le conducteur 7 de la troisième ligne de puissance et séparée de la deuxième piste 8 par une couche isolante 9 peut, elle aussi, avoir, au moins localement, une largeur de trois unités 18 et s'étend globalement entre les trois premières bornes 3 et les trois deuxièmes bornes 5, mais dans une troisième couche conductrice 11 de la carte de circuit imprimé 10, plus éloignée de la face connectée 13 que la deuxième couche conductrice 11. La troisième piste 8 présente une troisième cheminée 12 qui s'étend en direction de la face connectée 13 de la carte imprimée 10, à proximité de la première borne 3 de la troisième ligne. La troisième cheminée 12 peut donc traverser la deuxième couche conductrice 11 de la carte de circuit de circuit imprimé 10, compte tenu de la forme de la deuxième piste 8 qui s'y trouve et donc traverser la deuxième piste 8, formant le conducteur 7 de la deuxième ligne. La troisième cheminée 12 peut donc être reliée à la première borne 3 de la troisième ligne de puissance puis rejoindre la troisième piste 8 notamment, d'une part, en traversant la première couche conductrice 11 de la carte de circuit imprimé 10, compte tenu de la forme de la première piste 8 qui s'y trouve et donc en traversant la première piste 8, formant le conducteur 7 de la première ligne, et d'autre part, en traversant la deuxième couche conductrice 11 de la carte de circuit imprimé 10, compte tenu de la forme de la deuxième piste 8 qui s'y trouve et donc en traversant ladite deuxième piste 8, formant le conducteur 7 de la deuxième ligne.

Ainsi, à proximité des premières bornes 3, la au moins une piste 8 du conducteur 7 de chaque ligne de puissance du bloc 1 présente une portion à partir de laquelle s'étend une cheminée 12 en direction d'une face connectée 13 de la carte de circuit imprimée 10, aucune piste 8 du conducteur 7 d'une autre ligne de puissance ne se superposant à cette portion.

Les formes que présentent les première, deuxième et troisième pistes 8 au niveau des premières bornes 3 sont évidemment adaptées au niveau des deuxièmes bornes 5. Les pistes 8 peuvent aussi être adaptées à laisser passer plus d'une cheminée 12 par autre conducteur 7.

Avantageusement, afin d'augmenter l'ampérage pouvant transiter dans une ligne de puissance sans pour autant augmenter la dimension du bloc 1 dans la direction dans laquelle sont alignées les premières bornes 3, et selon une caractéristique supplémentaire possible, le conducteur 7 d'au moins une ligne de puissance est un conducteur stratifié 14, c'est-à-dire un conducteur 7 qui présente une pluralité de pistes 8 reliés électriquement dont au moins deux sont disposées dans des couches conductrices 11 différentes de circuit imprimé, notamment des pistes 8 se superposant, et qui est réalisé avec la technologie des circuit imprimés multicouches. Préférentiellement, toutes les pistes 8 formant le au moins un conducteur stratifié 14 sont globalement superposées, c'est-à-dire que leur projection orthogonale dans le plan de la carte de circuit imprimé 10 est sensiblement la même.

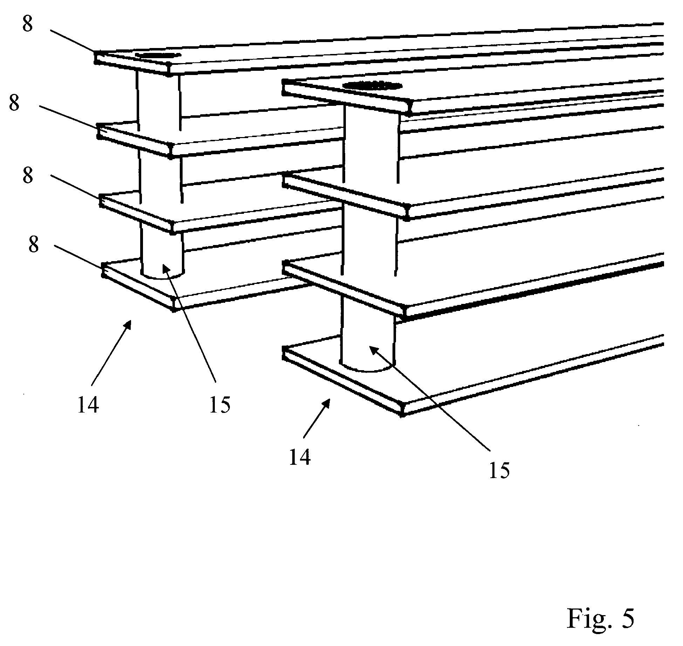

Cette caractéristique amène à un troisième type de réalisations, illustré à la figure 5 sous la forme d'un bloc 1 contrôlant deux lignes de puissance, le conducteur 7 de chacune d'elles étant un conducteur stratifié 14, fait de plusieurs pistes 8 superposées et réparties dans des couches conductrices 11 différentes d'une seule carte de circuit imprimé 10. Dans cette figure, le conducteur stratifié 14 d'une ligne de puissance n'est pas superposé au conducteur stratifié 14 d'une autre ligne de puissance, mais seules les pistes 8 d'un même conducteur stratifié 14 se superposent. Les conducteurs stratifiés 14 sont donc alignés l'un à côté de l'autre. Par exemple, il est possible de réaliser un conducteur stratifié 14 au moyen de trois ou quatre pistes 8 superposées, s'étendant chacune environ de la première borne 3 jusqu'à la deuxième borne 5 de la ligne de puissance à laquelle appartient ledit conducteur stratifié 14.

Dans ce troisième type de réalisations, et selon une caractéristique supplémentaire possible, le au moins un conducteur stratifié 14 présente au moins une jonction 15, reliant électriquement ses différentes pistes 8. Cette jonction 15, ou via, relie électriquement au moins deux pistes 8 d'un même conducteur stratifié 14.

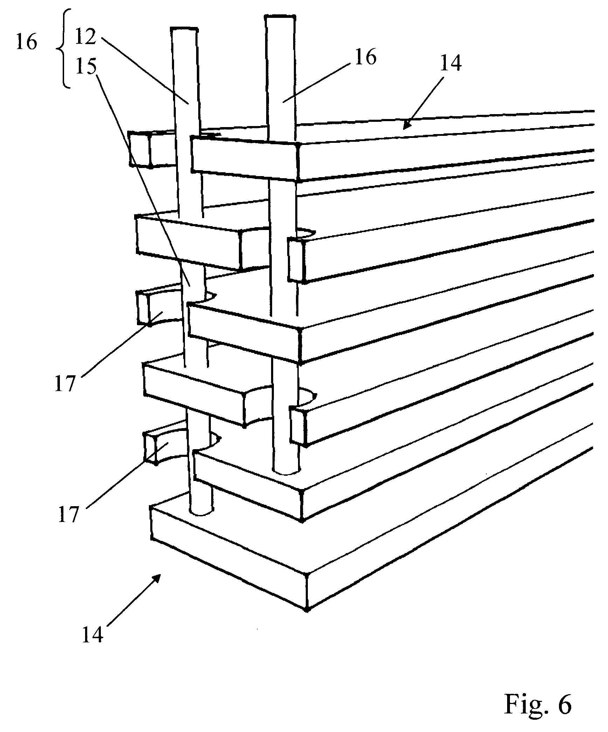

Dans des mises en oeuvre particulières, et selon une caractéristique possible illustrée à la figure 6, les conducteurs stratifiés 14 présentent, en outre, au moins une cheminée 12, s'étendant en direction de la face connectée 13 de la carte de circuit imprimée 10. Dans ces cas, afin de simplifier la fabrication, et selon une caractéristique supplémentaire possible, le au moins un conducteur stratifié 14 comprend au moins un puits 16 formant à la fois la au moins une cheminée 12 et la au moins une jonction 15. Un puits 16 forme donc à la fois une jonction 15 entre les pistes 8 d'un même conducteur stratifié 14 et une cheminée 12. Il est ainsi avantageux de prévoir un puits 16, ou via, sous la forme d'un tube creux, grâce auquel le contact électrique peut se faire le long de la surface intérieure dudit tube creux, favorisant ainsi une bonne répartition de la chaleur provoquée par la circulation électrique dans la ligne de puissance.

D'après une caractéristique supplémentaire possible, le bloc 1 électrique présente, d'une part, un premier conducteur 7, sous la forme d'un premier conducteur stratifié 14, et, d'autre part, un deuxième conducteur 7 avec lequel il est globalement superposé, la au moins une jonction 15 du au moins un premier conducteur stratifié 14 traversant au moins une piste 8 du deuxième conducteur 7 ajourée de façon à ne pas être en contact avec ladite au moins une jonction 15, notamment en présentant une poche 17, le deuxième conducteur 7 étant éventuellement aussi un conducteur stratifié 14.

Cette caractéristique amène à un quatrième type de réalisation, illustré à la figure 6 sous la forme d'un bloc 1 où les conducteurs 7 sont superposés deux à deux et où la au moins une piste 8 du deuxième conducteur 7 est ajourée en présentant au moins une poche 17 dans laquelle peut passer la jonction 15 reliant au moins deux pistes 8 du premier conducteur stratifié 14. Il est ainsi possible de connecter entre elles au moins deux premières pistes 8 superposées et appartenant chacune au conducteur stratifié 14 d'une première ligne de puissance sans toutefois venir en contact électrique avec une deuxième piste 8 du conducteur 7 d'une deuxième ligne de puissance, cette deuxième piste 8 étant située entre les deux premières pistes 8. La deuxième piste 8 peut former à elle seule le conducteur 7 de la deuxième ligne de puissance ou, comme le montre la figure 6, n'être qu'une piste 8 parmi la pluralité de pistes 8 superposées et formant le conducteur 7 de la deuxième ligne, ce dernier étant alors un conducteur stratifié 14.

Il peut donc aussi s'agir d'une paire de conducteurs stratifiés 14, comme l'illustre la figure 6, dont les pistes 8 sont superposées de sorte à former un empilement de pistes 8 appartenant alternativement à un premier conducteur stratifié 14 et à un deuxième conducteur stratifié 14. Chaque piste 8 présente donc une poche 17 dans laquelle peut circuler une jonction 15 reliant au moins les deux autres pistes 8 les plus proches dans l'empilement de pistes 8. Avantageusement, les poches 17 des pistes 8 d'un même conducteur stratifié 14 se superposent, de sorte qu'une seule et même jonction 15 linéaire peut être utilisée pour relier les pistes 8 de l'autre conducteur stratifié 14. Le principe peut être adapté à la superposition de plus de deux conducteurs stratifiés 14, la jonction 15 d'un conducteur stratifié 14 pouvant alors être amenée à traverser des pistes 8 appartenant à plus d'un autre connecteur stratifié 14.

Dans le mode de réalisation particulier illustré aux figures 7 et 8, et combinant, en outre, des caractéristiques déjà décrites, les conducteurs 7 de toutes les lignes de puissance du bloc 1 électrique sont des conducteurs stratifiés 14 appartenant à la même carte de circuit imprimé 10, les conducteurs stratifiés 14 de deux lignes de puissance disposées l'une à côté de l'autre dans le bloc 1 électrique se chevauchent en un empilement de pistes 8 appartenant alternativement à l'un des deux conducteurs stratifiés 14 superposés, chaque conducteur stratifié 14 présente, à chacune de ses deux extrémités, deux puits 16 formant chacun, d'une part, une jonction 15 entre ses pistes 8 superposées, et, d'autre part, une cheminée 12 s'étendant en direction d'une face connectée 13 de la carte de circuit imprimé 10 et grâce auxquels le conducteur stratifié 14 peut être relié soit à la première borne 3 soit à la deuxième borne 5, et chaque piste 8 de chacun des deux conducteurs stratifiés 14 superposés présente une forme adaptée pour n'être en contact avec aucun des puits 16 de l'autre conducteur stratifié 14, notamment en présentant des poches 17 dans lesquelles ces puits 16 peuvent s'étendre.

Dans ce mode de réalisation, le bloc 1 contrôle dix lignes de puissance, chacune d'elles comportant un conducteur stratifié 14 dont les pistes 8 ont les mêmes formes et se superposent. Comme déjà mentionné, l'utilisation d'un conducteur stratifié 14 permet de faire circuler une plus grande énergie sans pour autant augmenter la température ou nécessiter un plus grand bloc 1. Les premières bornes 3 sont toutes alignées en une rangée, dans une direction représentant la largeur du bloc 1, sur une première face 4 de ce dernier. Pour chaque ligne de puissance, la première borne 3 et la deuxième borne 5 sont en vis-à-vis, les deuxièmes bornes étant donc alignées sur une deuxième face 6, en vis-à-vis de la première face 4. La zone occupée par le circuit de puissance du bloc 1 est donc d'environ dix unités 18.

Le bloc 1 comprend une carte de circuit imprimé 10 portant l'ensemble des pistes 8 des dix conducteurs stratifiés 14, ainsi qu'une partie, et préférentiellement l'ensemble, d'une part, des composants électroniques du circuit de très basse tension 2, et, d'autre part, des portions conductrices de ce circuit.

Chaque conducteur stratifié 14 comprend trois pistes 8 s'étendant sensiblement de la première borne 3 à la deuxième borne 5, comme le montre la figure 8. La largeur de la piste 8 est aménagée en fonction des zones où se trouvent les pattes de composants électroniques du circuit de très basse tension 2, fixés sur la carte de circuit imprimé 10 du côté de la face connectée 13 et traversant au moins en partie ladite carte.

Les conducteurs stratifiés 14 sont superposés par paire. Ainsi, le premier conducteur stratifié 14 de la rangée est superposé au deuxième, le troisième est superposé au quatrième et ainsi de suite. Chaque paire de conducteurs stratifiés 14 superposés forme ainsi un empilement de pistes 8 qui appartiennent alternativement à l'un des deux conducteurs stratifiés 14 et qui sont disposées dans des couches conductrices 11 différentes de la carte de circuit imprimé 10. Les couches conductrices 11 auxquelles appartiennent deux pistes 8 successives de l'empilement sont séparées par une couche isolante 9, garantissant ainsi une bonne isolation entre les conducteurs stratifiés 14 de deux lignes de puissance différentes.

A proximité des premières bornes de connexion 3, les pistes 8 d'un même conducteur stratifié 14 d'une paire de conducteurs stratifiés 14 superposés n'occupent pas une largeur de deux unités 18, mais uniquement d'au plus une unité 18, présentant ainsi une poche 17 dans laquelle peuvent circuler deux puits 16 de l'autre conducteur stratifié 14 de ladite paire. Il en est de même à proximité des deuxièmes bornes de connexion 5.

Chaque conducteur stratifié 14 présente ainsi, entre autres, quatre puits 16, prenant chacun la forme d'un tube métallique creux, chacun constituant tant une jonction 15 entre les pistes 8 d'un même conducteur stratifié 14 qu'une cheminée 12 jusqu'à la face connectée 13. La moitié de ces quatre puits 16 est situé à proximité de la première borne 3, l'autre moitié étant situé à proximité de la deuxième borne 5, ces quatre puits permettant les connexions du conducteur stratifié 14 à la première borne 3 ou à la deuxième borne 5.

Chaque conducteur stratifié 14 est formé d'un empilement de pistes 8, chaque piste 8 présentant au moins une discontinuité 19, la séparant en au moins deux portions conductrices, électriquement connectées par au moins un relais 21 piloté par le circuit de très basse tension 2.

De plus, pour chacun des conducteurs stratifiés 14 du bloc 1, les discontinuités 19 des pistes 8 sont superposées. Chaque conducteur stratifié 14 présente alors, en outre, quatre autres puits 16, répartis deux à deux de chaque côté des discontinuités 19 et permettant de fixer au moins un relais 21 contrôlant le passage du courant à travers les discontinuités 19 et contrôlant ainsi la conduction de la ligne électrique de puissance entre la première borne 3 et la deuxième borne 5.

Plus précisément, le au moins relais 21 du conducteur stratifié 14 est préférentiellement connecté, d'une part, à au moins un premier puits 16, formant au moins une première jonction 15 entre les différentes portions conductrices situées d'un premier côté de la discontinuité 19, et, d'autre part, à au moins un deuxième puits 16, formant au moins une deuxième jonction 15 entre les différentes portions conductrices situées d'un deuxième côté de la discontinuité 19.

Comme le montre la figure 8, la piste 8 d'extrémité se situant au niveau de la face connectée 13 ne s'étend pas de la première borne 3 jusqu'à la deuxième borne 5 mais forme uniquement deux surfaces d'émergence 20 au niveau de la face connectée 13 pour les puits 16 du conducteur stratifié 14 reliant des pistes 8 se trouvant dans le coeur même de la carte de circuit imprimé 10. Les surfaces d'émergence 20 sont situées aux extrémités du conducteur stratifié 14, à proximité, pour l'une, de la première borne 3, et, pour l'autre, de la deuxième borne 5, au niveau de la face connectée 13. La surface d'émergence 20 présente elle aussi une discontinuité 19 superposée aux discontinuités 19 des autres pistes 8 du même conducteur stratifié 14, et est entourée, dans sa couche conductrice 11, de matière isolante formant en partie la surface de la face connectée 13. Différents puits 16 du conducteur stratifié 14 débouchent ainsi au niveau d'une surface d'émergence 20 et permettent la connexion, notamment, d'une part, entre le conducteur stratifié 14 et la première borne 3 ou la deuxième borne 5, et, d'autre part, d'au moins un relais 21, de chaque côté des discontinuités 19. Seules les pistes situées dans des couches inférieures de la carte de circuit imprimé 10 s'étendent donc depuis la première borne 3 jusqu'à la deuxième borne 5, ce qui permet ainsi d'utiliser une partie plus importante de la face connectée 13 pour installer des composants du circuit de très basse tension 2, puisqu'aucune piste 8, véhiculant un ampérage dangereux pour le circuit de très basse tension 2, ne s'étend, sur la face connectée 13, de la première face 4 à la deuxième face 6.

Afin d'améliorer l'isolation électrique entre l'environnement du bloc 1 et les pistes 8 des conducteurs stratifiés 14, il peut être prévu une couche de vernis de finition isolant sur la ou les dernières pistes 8 de l'empilement.

Enfin, selon une caractéristique supplémentaire possible, le conducteur 7 d'au moins une ligne de puissance présente une pluralité de pistes 8 dont au moins deux sont disposées dans la même couche conductrice 11 de circuit imprimé. Cette caractéristique est bien entendu aussi possible avec un conducteur stratifié 14.

Bien entendu, l'épaisseur de la piste 8 influence l'ampérage maximal qu'elle peut faire circuler sans dépasser un échauffement limite. Cette épaisseur est donc généralement ajustée à l'utilisation, dans les limites des capacités de la technologie de fabrication.

Grâce à l'utilisation de la technologie des circuits imprimés, et en particulier grâce au faible volume d'un circuit imprimé, au fait qu'il intègre en une seule pièce les portions conductrices et l'isolant nécessaire, et que les interfaces obtenues entre la matière conductrice et la matière isolante sont de bonne qualité, il est possible d'obtenir un moyen de connexion électrique entre l'entrée et la sortie d'une ligne de puissance d'un bloc électrique de contrôle piloté par un circuit de très basse tension, ce moyen de connexion présentant un encombrement, un coût et une difficulté de mise en place réduits, ainsi qu'une isolation accrue entre chaque ligne de puissance, entre l'ensemble des lignes de puissance et l'environnement, et entre le circuit de contrôle et les lignes de puissance.

En outre, grâce à l'utilisation, entre autres, d'un circuit imprimé multicouche pour réaliser des conducteurs superposés, notamment des conducteurs stratifiés superposés et d'un tube creux pour former une jonction entre les pistes d'un même conducteur et/ou une cheminée pour connecter ledit conducteur, la surface intérieure de ces tubes répartissant le passage d'énergie, il est possible de limiter l'échauffement du bloc électrique, qui est du, pour sa plus grande proportion, à la circulation d'un courant élevé dans les lignes de puissance, tout en conservant un volume de bloc réduit.

Enfin, l'utilisation de pistes électriques ajourées permet de faire circuler des vias jusqu'à un même coté d'une carte de circuit imprimé dans laquelle se trouvent tous les conducteurs, permettant ainsi de les relier électriquement tous depuis le même côté de ladite carte.

Les différentes caractéristiques et types de réalisations présentés ci-dessus peuvent bien sûr être combinés sans sortir du cadre de l'invention.

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention.

## Revendications

1. Bloc (1) électrique domotique comprenant au moins deux lignes de puissance dont il contrôle l'état électrique, notamment la conductivité, un circuit de très basse tension (2) pour son pilotage, ainsi que, pour chaque ligne de puissance électrique, d'une part, une première borne (3) de connexion, disposée au niveau d'une première face (4) du bloc (1) électrique, les premières bornes (3) étant alignées en une rangée, ainsi qu'une deuxième borne (5) de connexion, disposée au niveau d'une deuxième face (6) du bloc (1) électrique, la première borne (3) et la deuxième borne (5) étant en vis-à-vis, la première face (4) et la deuxième face (6) étant préférentiellement disposées en vis-à-vis l'une de l'autre, et, d'autre part, un conducteur (7), s'étendant sensiblement de la première borne (3) à la deuxième borne (5) et participant à mettre en communication électrique la première borne (3) de connexion et la deuxième borne (5) de connexion, ce bloc (1) électrique étant **caractérisé en ce que**
le conducteur (7) d'au moins une ligne de puissance électrique, et préférentiellement le conducteur (7) de chacune d'elles, est sous la forme d'un circuit imprimé, c'est-à-dire d'au moins une piste (8) de matière conductrice, telle que du cuivre, et d'au moins une couche isolante (9) sur laquelle ladite piste (8) repose, **en ce que**,
pour toutes les lignes de puissance du bloc (1), le conducteur (7) est sous la forme d'un circuit imprimé, les conducteurs (7) d'au moins deux lignes électriques, et préférentiellement les conducteurs (7) de toutes les lignes électriques, faisant partie d'une même carte de circuit imprimé (10) que comprend le bloc (1), et **en ce que**
pour au moins deux lignes de puissance électriques, le conducteur (7) d'une ligne de puissance est superposé au conducteur (7) d'une autre ligne de puissance, sur au moins une partie de leur longueur, la carte de circuit imprimé (10) étant un circuit imprimé multicouche fait essentiellement d'une superposition de couches conductrices (11) et de couches isolantes (9), la au moins une piste (8) de matière conductrice du conducteur (7) d'une ligne de puissance, d'une part, et la au moins une piste (8) de matière conductrice du conducteur (7) d'une autre ligne de puissance, d'autre part, étant superposées et disposées dans des couches conductrices (11) différentes de la carte de circuit imprimé (10).

2. Bloc (1) électrique selon la revendication 1, **caractérisé en ce que** la carte de circuit imprimé (10) comprend, en outre, des portions conductrices appartenant au circuit de très basse tension (2) et en accueille au moins une partie des composants.

3. Bloc (1) électrique selon l'une quelconque des revendications 1 ou 2, **caractérisé en ce que** le conducteur (7) d'au moins une ligne de puissance présente au moins une cheminée (12) s'étendant, en direction d'une face connectée (13) de la carte de circuit imprimé (10), depuis l'une de ses pistes (8), préférentiellement sa piste (8) la plus proche de ladite face connectée (13), en traversant éventuellement au moins une piste (8) d'un autre conducteur (7) alors ajourée de façon à ne pas être en contact avec ladite cheminée (12) notamment en présentant une poche (17).

4. Bloc (1) électrique selon l'une quelconque des revendications 1 à 3, **caractérisé en ce que** le conducteur (7) d'au moins une ligne de puissance est un conducteur stratifié (14), c'est-à-dire un conducteur (7) qui présente une pluralité de pistes (8) reliés électriquement dont au moins deux sont disposées dans des couches conductrices (11) différentes de circuit imprimé, notamment des pistes (8) se superposant, et qui est réalisé avec la technologie des circuit imprimés multicouches.

5. Bloc (1) électrique selon la revendication 4, **caractérisé en ce que** le au moins un conducteur stratifié (14) présente au moins une jonction (15), reliant électriquement ses différentes pistes (8).

6. Bloc (1) électrique selon la revendication 3 et la revendication 5, **caractérisé en ce que** le au moins un conducteur stratifié (14) comprend au moins un puits (16) formant à la fois la au moins une cheminée (12) et la au moins une jonction (15).

7. Bloc (1) électrique selon la revendication 5, **caractérisé en ce qu'**il présente, d'une part, un premier conducteur (7), sous la forme d'un premier conducteur stratifié (14), et, d'autre part, un deuxième conducteur (7) avec lequel il est globalement superposé, la au moins une jonction (15) du au moins un premier conducteur stratifié (14) traversant au moins une piste (8) du deuxième conducteur (7) ajourée de façon à ne pas être en contact avec ladite au moins une jonction (15), notamment en présentant une poche (17), le deuxième conducteur (7) étant éventuellement aussi un conducteur stratifié (14).

8. Bloc (1) électrique selon la revendication 7, **caractérisé en ce que** les conducteurs (7) de toutes les lignes de puissance du bloc (1) électrique sont des conducteurs stratifiés (14) appartenant à la même carte de circuit imprimé (10), les conducteurs stratifiés (14) de deux lignes de puissance disposées l'une à côté de l'autre dans le bloc (1) électrique se chevauchent en un empilement de pistes (8) appartenant alternativement à l'un des deux conducteurs stratifiés (14) superposés, chaque conducteur stratifié (14) présente, à chacune de ses deux extrémités, deux puits (16) formant chacun, d'une part, une jonction (15) entre ses pistes (8) superposées, et, d'autre part, une cheminée (12) s'étendant en direction d'une face connectée (13) de la carte de circuit imprimé (10) et grâce auxquels le conducteur stratifié (14) peut être relié soit à la première borne (3) soit à la deuxième borne (5), et chaque piste (8) de chacun des deux conducteurs stratifiés (14) superposés présente une forme adaptée pour n'être en contact avec aucun des puits (16) de l'autre conducteur stratifié. (14), notamment en présentant des poches (17) dans lesquelles ces puits (16) peuvent s'étendre.

9. Bloc (1) électrique selon l'une quelconque des revendications 1 à 8, **caractérisé en ce que** le conducteur (7) d'au moins une ligne de puissance présente une pluralité de pistes (8) dont au moins deux sont disposées dans la même couche conductrice (11) de circuit imprimé.

## Patentansprüche

1. Elektrischer haustechnischer Block (1), umfassend wenigstens zwei Leistungsleitungen, welcher deren elektrischen Zustand, insbesondere die Leitfähigkeit steuert, einen Stromkreis mit sehr niedriger Spannung (2) für seine Steuerung ebenso wie für jede elektrische Leistungsleitung einerseits, einen ersten Verbindungsanschluss (3), der an einer ersten Seite (4) des elektrischen Blocks (1) angeordnet ist, wobei die ersten Anschlüsse (3) in Reihe ausgerichtet sind, ebenso wie einen zweiten Verbindungsanschluss (5), der an einer zweiten Seite (6) des elektrischen Blocks (1) angeordnet ist, wobei der erste Anschluss (3) und der zweite Anschluss (5) gegenüberliegen, wobei die erste Seite (4) und die zweite Seite (6) vorzugsweise einander gegenüberliegen, und andererseits einen Leiter (7), der sich im Wesentlichen von dem ersten Anschluss (3) zu dem zweiten Anschluss (5) erstreckt und daran beteiligt ist, eine elektrische Kommunikation zwischen dem ersten Verbindungsanschluss (3) und dem zweiten Verbindungsanschluss (5) herzustellen, wobei der elektrische Block (1) **dadurch gekennzeichnet ist, dass**
der Leiter (7) wenigstens einer elektrischen Leistungsleitung und vorzugsweise der Leiter (7) jeder dieser die Form einer gedruckten Schaltung hat, d.h. wenigstens eine Leiterbahn (8) aus einem leitfähigen Material wie etwa Kupfer und eine isolierende Schicht (9), auf der die Leiterbahn (8) aufliegt, **dadurch gekennzeichnet, dass**
bei allen Leistungsleitungen des Blocks (1) der Leiter (7) die Form einer gedruckten Schaltung hat, wobei die Leiter (7) von wenigstens zwei elektrischen Leitungen und vorzugsweise die Leiter (7) aller elektrischen Leitungen Teil einer gleichen gedruckten Schaltkreisplatine (10) sind, welche der Block (1) umfasst, **dadurch gekennzeichnet, dass**
bei wenigstens zwei elektrischen Leistungsleitungen der Leiter (7) einer Leistungsleitung einem Leiter (7) einer anderen Leistungsleitung über wenigstens einen Teil ihrer Länge überlagert ist, wobei die gedruckte Schaltkreisplatine (10) ein gedruckter mehrlagiger Schaltkreis ist, der im Wesentlichen aus einer Überlagerung von leitfähigen Schichten (11) und isolierenden Schichten (9) gebildet ist, wobei die wenigstens eine Leiterbahn (8) aus leitfähigem Material des Leiters (7) einer Leistungsleitung einerseits und die wenigstens eine Leitungsbahn (8) aus leitfähigem Material des Leiters (7) einer anderen Leistungsleitung andererseits überlagert sind und in verschiedenen leitfähigen Schichten (11) der gedruckten Stromkreisplatine (10) angeordnet sind.

2. Elektrischer Block (1) nach Anspruch 1, **dadurch gekennzeichnet, dass** die gedruckte Stromkreisplatine (10) darüber hinaus leitfähige Abschnitte umfasst, die zu einem Schaltkreis mit sehr niedriger Spannung (2) gehören und darin wenigstens einen Abschnitt der Bauteile aufnimmt.

3. Elektrischer Block (1) nach einem der Ansprüche 1 oder 2, **dadurch gekennzeichnet, dass** der Leiter (7) wenigstens einer Leistungsleitung wenigstens einen Pfad (12) aufweist, der sich in Richtung einer verbundenen Seite (13) der gedruckten Stromkreisplatine (10) von einer ihrer Leiterbahnen (8), vorzugsweise von der Leiterbahn (8), die der verbundenen Seite (13) am nächsten liegt, erstreckt, wobei er gegebenenfalls wenigstens eine Leiterbahn (8) eines anderen Leiters (7) überquert, die dann in der Form unterbrochen ist, dass sie nicht in Kontakt mit dem Pfad (12) steht und insbesondere eine Tasche (17) bildet.

4. Elektrischer Block (1) nach einem der Ansprüche 1 bis 3, **dadurch gekennzeichnet, dass** der Leiter (7) wenigstens einer Leistungsleitung ein geschichteter Leiter (14) ist, d.h. ein Leiter (7), welcher eine Vielzahl von elektrisch verbundenen Leiterbahnen (8) aufweist, von denen wenigstens zwei in unterschiedlichen leitfähigen Schichten (11) des gedruckten Schaltkreises angeordnet sind, wobei insbesondere die Leiterbahnen (8) überlagert sind und der mittels der Technologie der mehrschichtigen gedruckten Schaltkreise hergestellt ist.

5. Elektrischer Block (1) nach Anspruch 4, **dadurch gekennzeichnet, dass** der wenigstens eine geschichtete Leiter (14) wenigstens eine Verbindung (15) aufweist, die seine unterschiedlichen Leiterbahnen (8) elektrisch verbindet.

6. Elektrischer Block (1) nach Anspruch 3 und Anspruch 5, **dadurch gekennzeichnet, dass** der wenigstens eine geschichtete Leiter (14) wenigstens einen Schacht (16) umfasst, der gleichzeitig den wenigstens einen Pfad (12) und die wenigstens eine Verbindung (15) bildet.

7. Elektrischer Block (1) nach Anspruch 5, **dadurch gekennzeichnet, dass** er einerseits einen ersten Leiter (7) in Form eines ersten geschichteten Leiters (14) und andererseits einen zweiten Leiter (7) aufweist, mit welchem er vollständig überlagert ist, wobei wenigstens eine Verbindung (15) des wenigstens ersten geschichteten Leiters (14) wenigstens eine Leiterbahn (8) des zweiten Leiters (7) überquert, die in der Form unterbrochen ist, dass sie keinen Kontakt mit der ersten Verbindung (15) herstellt und insbesondere eine Tasche (17) aufweist, wobei der zweite Leiter (7) gegebenenfalls ebenfalls ein geschichteter Leiter (14) ist.

8. Elektrischer Block (1) nach Anspruch 7, **dadurch gekennzeichnet, dass** die Leiter (7) aller Leistungsleitungen des elektrischen Blocks (1) geschichtete Leiter (14) sind, die zu der gleichen gedruckten Schaltkreisplatine (10) gehören, wobei sich die geschichteten Leiter (14) von zwei nebeneinander in dem elektrischen Block (1) angeordneten Leistungsleitungen in einem Stapel von Leiterbahnen (8), die abwechselnd zu einem der beiden überlagerten geschichteten Leiter (14) gehören, überlappen, wobei jeder geschichtete Leiter (14) an seinen beiden Enden zwei Schächte (16) aufweist, die jeweils einerseits eine Verbindung zwischen seinen überlagerten Leiterbahnen (8) und andererseits einen Pfad (12) bilden, der sich in Richtung einer verbundenen Seite (13) der gedruckten Schaltkreisplatine (10) erstreckt und dank derer die geschichteten Leiter (14) entweder mit dem ersten Anschluss (3) oder dem zweiten Anschluss (5) verbunden werden können, und wobei jede Leiterbahn (8) von jeder der beiden überlagerten geschichteten Leiter (14) eine Form aufweist, die geeignet ist, um nicht in Kontakt mit einem der Schächte (16) des anderen geschichteten Leiters (14) zu gelangen, insbesondere Taschen (17) aufweist, in denen die Schächte (16) sich erstrecken können.

9. Elektrischer Block (1) nach einem der Ansprüche 1 bis 8, **dadurch gekennzeichnet, dass** der Leiter (7) wenigstens einer Leistungsleitung eine Vielzahl von Leiterbahnen (8) aufweist, von denen wenigstens zwei in der gleichen leitfähigen Schicht (11) des gedruckten Schaltkreises angeordnet sind.

## Claims

1. Electric home unit (1) comprising at least two power lines, the electrical state of which is controlled by the unit, in particular the conductivity, a very low voltage circuit (2) for controlling the latter, as well as for each electric power line, on the one hand, a first connection terminal (3), arranged on a first face (4) of the electric unit (1), the first terminals (3) being aligned in a row, as well as a second connection terminal (5), arranged on a second face (6) of the electric unit (1), the first terminal (3) and the second terminal (5) facing one another, the first face (4) and the second face (6) being preferably arranged facing one another and on the other hand a conductor (7) extending substantially from the first terminal (3) to the second terminal (5) and putting into electrical communication the first connection terminal (3) and the second connection terminal (5), said electric unit (1) being **characterised in that**
the conductor (7) of at least one electric power line and preferably the conductor (7) of each one is in the form of a printed circuit, that is at least one track (8) of conducting material, such as copper, and at least one insulating layer (9) on which the said track (8) lies, **in that**
for all of the power lines of the block (1), the conductor (7) is in the form of a printed circuit, the conductors (7) of at least two electric lines and preferably, the conductors (7) of all the electric lines, forming part of the same printed circuit board (10) that the block (1) comprises and **in that** for at least two electric power lines, the conductor (7) of a power line is superimposed on the conductor (7) of another power line over at least part of their length, the printed circuit board (10) being a multi-layered printed circuit consists essentially of a layering of conducting layers (11) and insulating layers (9), the at least one track (8) of conducting material of the conductor (7) of a power line on the one hand and the at least one track (8) of conducting material of the conductor (7) of another power line on the other hand being superimposed and arranged in different conducting layers (11) of the printed circuit board (10).

2. Electric unit (1) according to claim 1, **characterised in that** the printed circuit board (10) also comprises conducting portions belonging to the very low voltage circuit (2) and accommodates at least a portion of the components.

3. Electric unit (1) according to any one of claims 1 or 2, **characterised in that** the conductor (7) of at least one power line has at least one chute (12) extending in the direction of a connected face (13) of the printed circuit board (10) from one of its tracks (8), preferably its track (8) closest to the said connected face (13), by possibly traversing at least one track (8) of another conductor (7) then punched so as not to be in contact with the said chute (12) in particular by forming a pocket (17).

4. Electric block (1) according to any one of claims 1 to 3, **characterised in that** the conductor (7) of at least one power line is a layered conductor (14), that is a conductor (7) which has a plurality of electrically connected tracks (8), at least two of which are arranged in different conducting layers (11) of the printed circuit, in particular superimposing tracks (8), and which is produced by means of the technology for multi-layered printed circuits.

5. Electric block (1) according to claim 4, **characterised in that** the at least one layered conductor (14) has at least one junction (15) connecting its different tracks (8) electrically.

6. Electric block (1) according to claim 3 and claim 5, **characterised in that** the at least one layered conductor (14) comprises at least one shaft (16) forming both the at least one chute (12) and the at least one junction (15).

7. Electric block (1) according to claim 5, **characterised in that** it comprises on the one hand a first conductor (7), in the form of a first layered conductor (14) and on the other hand a second conductor (7) with which it is superimposed broadly, the at least one junction (15) of the at least one first layered conductor (14) traversing at least one track (8) of the second conductor (7) which is punched so as not to be in contact with the said at least one junction (15), in particular by having a pocket (17), the second conductor (7) being also possibly a layered conductor (14).

8. Electric block (1) according to claim 7, **characterised in that** the conductors (7) of all of the power lines of the electric block (1) are layered conductors (14) belonging to the same printed circuit board (10), the layered conductors (14) of two power lines arranged next to one another in the electric unit (1) overlapping in a stack of tracks (8) belonging alternately to one of the two superimposed layered conductors (14), each layered conductor (14) has at each of its two ends two shafts (16) each forming on the one hand a junction (15) between its superimposed tracks (8) and on the other hand a chute (12) extending in the direction of a connected face (13) of the printed circuit board (10) and by means of which the layered conductor (14) can be connected either to the first terminal (3) or to the second terminal (5) and each track (8) of each of the two layered superimposed conductors (14) has a shape which is adjusted so as not be in contact with any of the shafts (16) of the other layered conductor (14), in particular by having pockets (17) into which said shafts (16) can extend.

9. Electric block (1) according to any one of claims 1 to 8, **characterised in that** the conductor (7) of at least one power line comprises a plurality of tracks (8), at least two of which are arranged in the same conducting layer (11) of the printed circuit.
